# EUROPEAN PATENT SPECIFICATION

(11) **EP 2 808 886 B1**
(45) Date of publication and mention of the grant of the patent: **21.10.2020**
(21) Application number: 14275128.8
(22) Date of filing: 27.05.2014
(51) Int. Cl.: H01J 37/32, C23C 16/455

(54) **Apparatus for processing a semiconductor workpiece**
Vorrichtung zur Verarbeitung eines Halbleiterwerkstücks
Appareil de traitement d'une pièce à semi-conducteur

(30) Priority: 29.05.2013 GB 201309583
(43) Date of publication of application: 03.12.2014
(73) Proprietor: SPTS Technologies Limited, Newport Gwent NP18 2TA (GB)
(72) Inventor: Ansell, Oliver, Bristol, Avon BS41 9DR (GB); Kiernan, Brian, Cardiff, CF24 3EN (GB); Jeffrey, Toby, Caerphilly, CF83 8QA (GB); Varvara, Maxime, 74350 Copponex (FR)
(74) Representative: Wynne-Jones IP Limited

(56) References cited:
- WO-A2-2012/125560
- JP-A- H10 284 291
- US-A1- 2009 142 929
- US-A1- 2011 177 694
- US-A1- 2012 024 479
- US-A1- 2012 244 684
- US-A1- 2012 285 622
- David Butler: "Production Solutions for Via Reveal", European 3D TSV Summit 2013, 22 January 2013 (2013-01-22), XP055135425, Retrieved from the Internet: URL:http://www.semi.org/eu/sites/semi.org/ files/docs/David_Butler%20Production%20sol utions%20for%20via%20reveal%20publish.pdf [retrieved on 2014-08-19]

## Description

This invention relates to apparatus for processing a semiconductor workpiece.

Plasma etching is extensively used in the fabrication of semiconductor devices. Cost effective manufacturing of devices requires plasma etch systems to remove the required layers quickly while maintaining the customer specified uniformities (such as etch rate, and selectivity) within and between processed wafers. Frequently there is a compromise to be made between average etch rate and uniformity as in many cases uniformities in the process performance degrade as etch rate is increased.

High rate anisotropic plasma etching of features in silicon wafers is typically achieved by the "Bosch process" [US 5501893] or cyclic deposition/etch processes [US 8133349]. Deposition and etch steps are cyclically carried out in a plasma etch tool to enable a relatively high removal rate of the silicon which is not protected by the mask. This type of process has widespread commercial application and is used to fabricate MEMS (micro electro mechanical systems), gyroscopes, accelerometers, sensors, through silicon vias (TSVs) and even wafer scribing or thinning. In all cases for cost reasons it is desirable to fabricate the part as rapidly as possible and as a consequence a great deal of effort has been applied to developing hardware and processes that enable the high etch rate of silicon.

It should however be understood that process uniformity is also a very important consideration. In most applications a number of parts (die) are patterned over a wafer and amount of material being removed from all parts should be similar. Ideally they should be the same but in practice achieving identical conditions can be very difficult to achieve. Parts at the centre and the edge of the wafer should be processed in a similar fashion if the maximum yield is to be maintained. It is also desirable that etch rate is the same or similar across the whole wafer. If this is not the case some parts will be completed prior to others and in some cases this may prove to be detrimental to the parts that experience over etching. To complicate matters further plasma uniformity may also influence angle of a feature being etched into the masked silicon wafer. Frequently at the edge of the wafer some of the ions hit the wafer surface at less than normal incidence. This results in a slight "tilt" in the anisotropic feature being etched. US 5683548 describes an ICP reactor where independent control of gas and RF can be applied to a series of concentric channels. By using concentric channels - generally in the same plane - some degree of radial plasma non-uniformity can be reduced near the channels. However, nonuniformities can still exist close to the wafer surface. US2011/0177694 discloses a two chamber apparatus which produces a switchable quasi-neutral beam to improve etch resistance of photoresist layers. Document JPH10284291 discloses a plasma processing device comprising a processing chamber with an upper section and a lower section and a dual RF source, wherein the processing speed is made uniform. The SPTS presentation by D. Butler at the 2013 European 3D TSV Summit, entitled "Production Solutions for Via Reveal", discloses and compares several generations of etching apparatus. The latest SPTS etching apparatus, i.e. the Pegasus rapier, comprises a dual RF source and may additionally comprise a wafer edge protection device.

The present invention, in at least some of its embodiments, addresses the abovementioned problems.

According to a first aspect of the invention there is provided an apparatus for processing a semiconductor workpiece as defined in claim 1, including:
a first chamber having a first plasma production source and a first gas supply for introducing a supply of gas into the first chamber;
a second chamber having a second plasma production source (30, 32) and a second gas supply for introducing a supply of gas into the second chamber, the second gas supply being independently controllable of the first gas supply;
a workpiece support positioned in the second chamber; a plurality of gas flow pathway defining elements arranged to define a gas flow pathway in the vicinity of the workpiece when positioned on the workpiece support, wherein the gas flow pathway defining elements include at least one wafer edge region protection element for protecting the edge of the wafer and/or a region outwardly circumjacent to the edge of the wafer, and at least one auxiliary element spaced apart from the at least one wafer edge region protection element such that the gas flow pathway is defined; characterized in that the at least one auxiliary element is spaced apart from the at least one wafer edge region protection element such that a gap of between 5 and 50 mm is defined.

The at least one wafer edge region protection device element may be an annular wafer edge protection device.

The at least one auxiliary element may include one or more baffles. The at least one auxiliary element may be an annular baffle.

The at least one auxiliary element may be positioned over an inner portion of the at least one wafer edge region protection element.

The at least one auxiliary element may be positioned over an outer part of the at least one wafer edge region protection element.

The at least one auxiliary element may extend radially inward of the wall of the second chamber.

The at least one auxiliary element may extend downwardly from the wall of the second chamber.

The at least one auxiliary element may be spaced apart from the at least one wafer edge region protection element such that a gap of between 15 and 25 mm is defined.

The gas flow pathway may extend radially outwards from the workpiece when positioned on the workpiece support.

The workpiece, when positioned on the workpiece support, may be supported by a carrier, and the at least one wafer edge region protection element is arranged to protect the carrier. The carrier may be of the tape and frame kind. The at least one wafer edge protection element may be arranged to protect the tape and/or the frame.

The first plasma production source may include an element for coupling energy into the first chamber such that a plasma induced in the first chamber is maintained, and the second plasma production source may include an element for coupling energy into the second chamber such that a plasma induced in the second chamber is maintained, wherein the element of the first plasma production source is spaced apart from the element of the second plasma production source such that the plasma induced in the first chamber is decoupled from the plasma induced in the second chamber. The apparatus may be configured so that no energy or only insignificant amounts of energy from the element for coupling energy into the first chamber is coupled into the second plasma. Alternatively, or additionally, the apparatus may be configured so that no energy or only insignificant amounts of energy from the element for coupling energy into the second chamber is coupled into the first plasma. In this way, the plasmas may be decoupled. The elements for coupling energy into the first and second chambers may be RF coils. The first chamber may be arranged to meet the second chamber at an interface having an associated level, and at least one of the elements of the first plasma production source and the elements of the second plasma production source may be spaced apart from said level.

The skilled reader will appreciate that the at least one auxiliary element is an element which is additional to the wall of the second chamber, although it may project from said wall.

Whilst the invention has been described above, it extends to any inventive combination of the features set out above, or in the following description, drawings or claims.

Embodiments of apparatus, including embodiments of apparatus in accordance with the invention, will now be described with reference to the accompanying drawings, in which:-
Figure 1 shows a first embodiment of an apparatus;
Figure 2 shows a second embodiment of an apparatus;
Figure 3 shows plasma cleaning of (a) the second chamber and (b) the first chamber of the apparatus of Figure 1;
Figure 4 shows normalised etch rate as a function of radial wafer position for a single RF source configuration and a dual RF source configuration;
Figure 5 shows normalised etch rate as a function of radial wafer position for a single RF source configuration with gas feed and a dual RF source configuration with separate gas feeds; and
Figure 6 shows etch rate uniformity with and without a gas conductance limiting pathway at the edge of a 200 mm blank silicon wafer.

Inductively coupled plasma (ICP) Plasma etch tools frequently use an RF antenna placed around a ceramic bell jar to produce a dense plasma. A central gas feed provides the gas to be disassociated in the bell jar and plasma nonuniformities are reduced through the use of a "diffusion chamber" a large diameter chamber which is placed between the plasma source and the wafer platen assembly. The diffusion chamber allows the plasma to expand to beyond the edge of the wafer. Gas is pumped from the chamber through a gate valve to the bottom of the system. The platen assembly will normally have an electrostatic chuck to aid heat removal from the wafer and an RF bias to aid the etch/deposition process. Although the invention is not limited to ICP plasma etch tools, for the purposes of illustration the invention will now be described in relation to etch tools of this type.

In the context of RF based, ICP plasma etch tools described in the accompanying drawings, features of the invention are as follows: a) two concentric RF sources, the primary source being located in the upper bell jar and the diameter of this jar being lower than that of the main chamber; b) two gas feeds, one to the primary source and the other being an annular arrangement to the upper part of the main chamber; and c) a conductance limiting path at the edge of the wafer to reduce the flow of gas at the wafer edge.

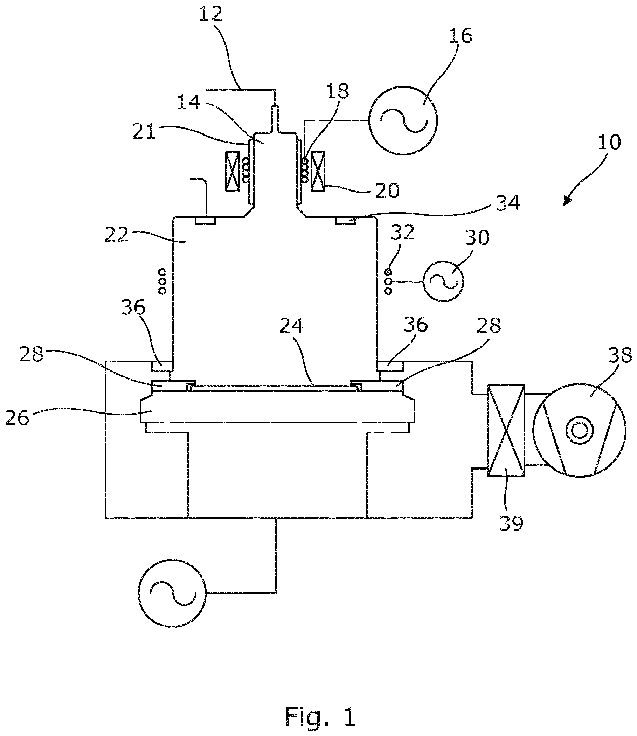

By judicious control of one or more of these factors, etch rate can be enhanced while uniformity can be maintained at acceptable levels. These features can be seen diagrammatically in Figure 1.

A secondary benefit of the invention is an improved plasma clean process capability. Plasma clean processes can be used to remove deposited material from the chamber walls. This is a very important factor which must be controlled to maintain wafer - wafer uniformity over time. An advantage of the present invention is that because the two plasma sources can be operated independently the operator can run clean regimes targeting specific areas of the chamber, (ICP only for main reaction chamber / high density plasma only for bell jar). The invention also makes it possible to shift the plasma around by using combination of the sources. More efficient cleaning will yield productivity benefits.

Figure 1 depicts a first configuration of apparatus of the invention, shown generally at 10. The primary gas feed 12 enters the primary chamber 14 (∼7-12 cm diameter dielectric cylinder) which has an associated primary ionization source 16. An RF antenna 18 nominally 13.56 MHz acts as the ICP source. This can be assisted by a DC 20 coil to modify the confinement of the plasma. A Faraday shield 21 can be provided between the DC coil 20 and the wall of the primary chamber 14 to reduce capacitive coupling. The plasma from the primary source enters the main chamber 22 where the wafer 24 is placed on the wafer support 26, which may be an electrostatic chuck. The wafer size could be up to 300 mm in standard production applications, although processing of still larger wafers is within the scope of the invention. The edge of the wafer 24 is protected by a wafer edge protection (WEP) device 28 to avoid excessive loss of silicon at the wafer edge where the resist edge bead has been removed. The main (secondary) chamber 22 has a secondary ionization source 30 having a secondary RF coil 32 placed around the main chamber 22 to provide a secondary plasma close to the chamber wall 22a. The RF coil 32 could also operate at 13.56 MHz or a lower frequency such as 1-2 MHz. It is possible to include a Faraday shield between the secondary RF coil 32 and the wall of the main chamber 22. This can be additional to the Faraday shield 21 positioned adjacent to primary chamber 14. Alternatively, the Faraday shield positioned adjacent the main chamber 22 can be instead of the Faraday shield 21, or no Faraday shield may be present. An annular gas distribution system 34 is incorporated into the main chamber 22 to provide an independent gas source for the secondary plasma. A conductance limiting pathway is introduced at the wafer edge. Gas flows above the WEP 28 and below an annular baffle 36 in a radial fashion to the pump 38 through a gate valve 39. The typical but non-limiting height of this gap is 5-50 mm. The conductance limiting path can increase the residence time of active gas species at the wafer edge and hence improve process uniformity.

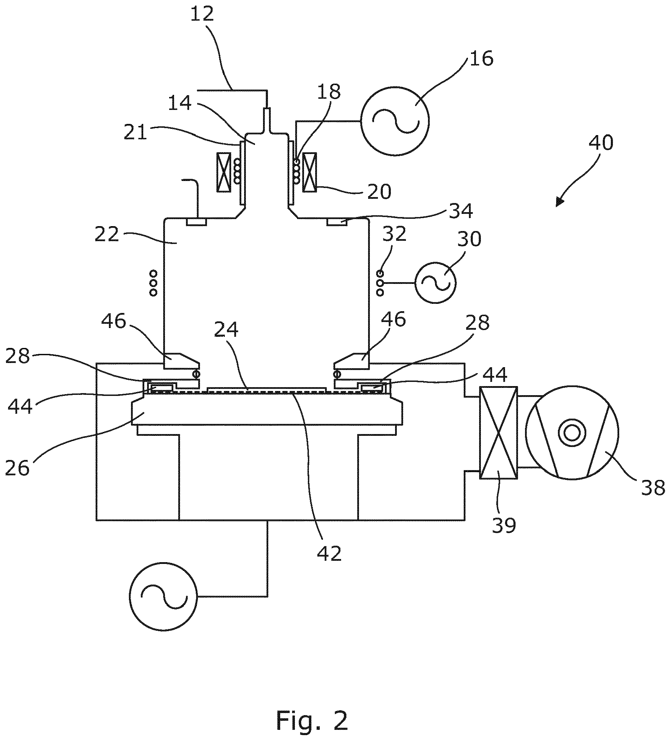

It is desirable that the WEP is maintained at an elevated temperature to reduce the deposition build up due to successive deposition cycles. This heating is preferably achieved by creating a plasma in the chamber 22 to heat all the interior before the wafer of interest is loaded. The plasma during the main process will ensure that the protection system continues to stay at a temperature of 85°C to 150°C. This WEP system can have an internal diameter greater than the wafer diameter to ensure that the whole wafer is exposed to the plasma, but material is protected outside the wafer diameter. This material could include the tape and/or frame of a wafer supported by tape or an alternative carrier. Such a configuration is shown in Figure 2. Figure 2 depicts a second configuration of apparatus of the invention, shown generally at 40. Many of the elements shown in Figure 2 are identical to elements shown in Figure 1, and identical reference numerals are used to denote such common elements.

In Figure 2 the wafer 24 is carried on a tape 42 and frame 44 arrangement. A wafer edge conductance limiting baffle 46 is attached above the wafer position, with an inner diameter close to the diameter of the wafer 24. The gap between the wafer 24 (or parts sitting on the wafer support 26 around the wafer 24) should be small enough to cause the etchant gas to mainly interact with the wafer 24 before being pumped around the side of the wafer support 26. In Figure 2 the gap between the WEP 28 which protects the tape 42 and frame 44 and the baffle 46 is identified by the arrow. A balance must be found between this mixing and the reduced conductance that this causes for pumping the etch products away from the wafer. As a guideline, the optimum gap size is between 5 and 50 mm. The baffle is applicable to many etch materials and process gases where a remote plasma source is used, including, but not limited to, Si, GaAs, polymer, Al, and fluorine, chlorine and oxygen based chemistries.

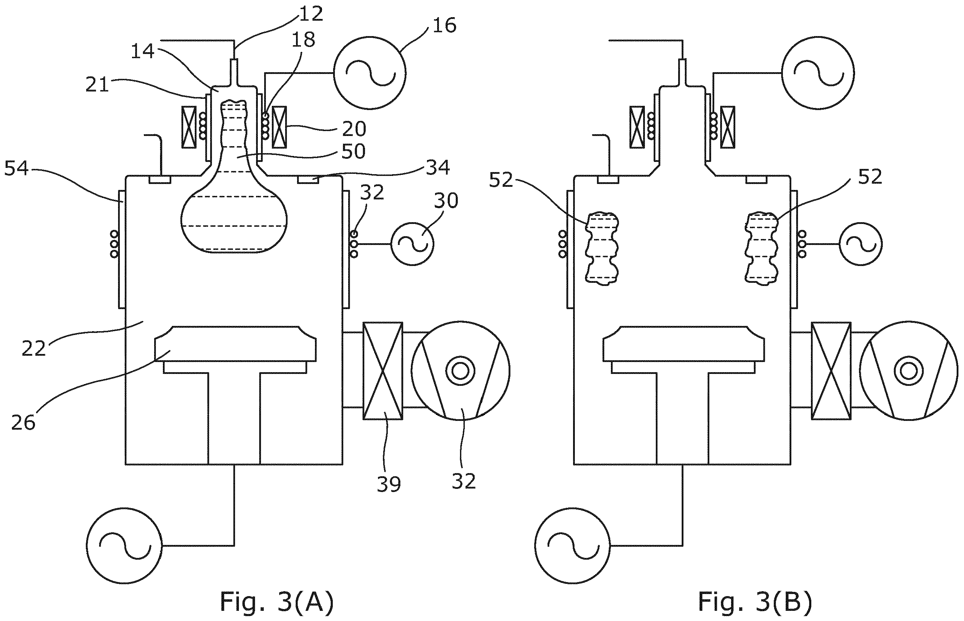

Cleaning the process chamber following an etch cycle or number of wafers is essential if process reproducibility is to be maintained over time. Plasma clean processes can be used to remove deposited material from the chamber walls and in turn increase the time between venting the chamber for a maintenance clean. The present invention provides apparatus having two plasma sources which can be operated independently, enabling specific clean regimes to be implemented which target specific areas of the chambers (ICP only for main chamber / high density plasma only for bell jar (primary chamber)). Figure 3 shows a) plasma cleaning of the primary chamber 14 and b) plasma cleaning of the primary chamber 22 using apparatus of the invention. The apparatus shown in Figure 3 is essentially identical to the apparatus 10 shown in Figure 1, and identical reference numerals are used to denote common elements. The apparatus shown in Figure 3 further comprises a second Faraday shield 54 provided between the secondary RF coil 32 and the wall of the main chamber 22. In Figure 3 a) a plasma 50 is produced in the primary chamber 14, and in Figure 3b) a plasma 52 is produced in the main chamber 22. This approach also makes it possible to shift the plasma around by using combination of the sources. More efficient cleaning will yield productivity benefits.

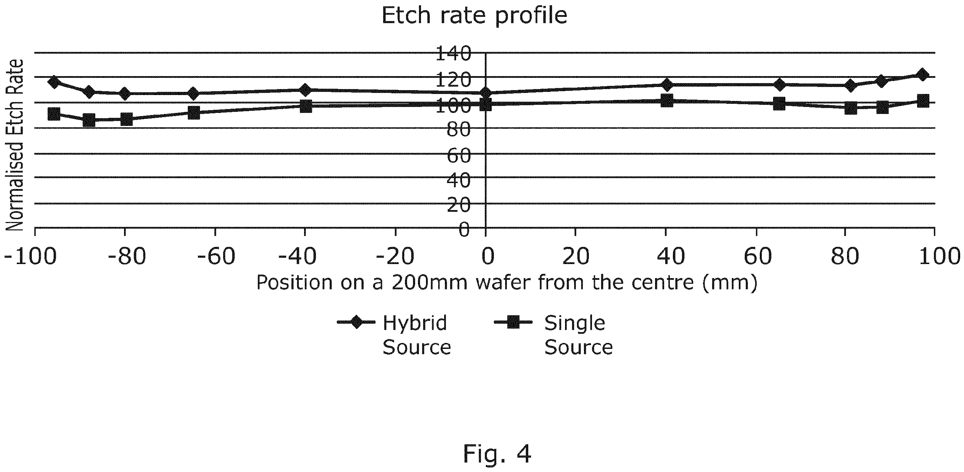

By using two independent sources - one primary source at the top of the chamber in a small ceramic / insulating container where the principal dissociation of the reactive gases will take place - and secondary auxiliary source between the primary source and the wafer - ideally close to the wafer - radial non- uniformities close to the wafer edge can be compensated by the auxiliary source. When using a single source the plasma density at the centre of the process chamber tends to be higher than at the edge. This is particularly pronounced using a small diameter tube as the first chamber. As the RF power applied to the antenna is increased, the non-uniformity can be increased. In Figure 4 we can see not only improved uniformity for 200 mm wafers but also higher normalised etch rate due to the use of the secondary RF source. The RF power for the primary source was maintained a 3kW for both sets of data but 1.5 kW power was used in the secondary source for the "hybrid source" measurements. Gas was only supplied to the primary source.

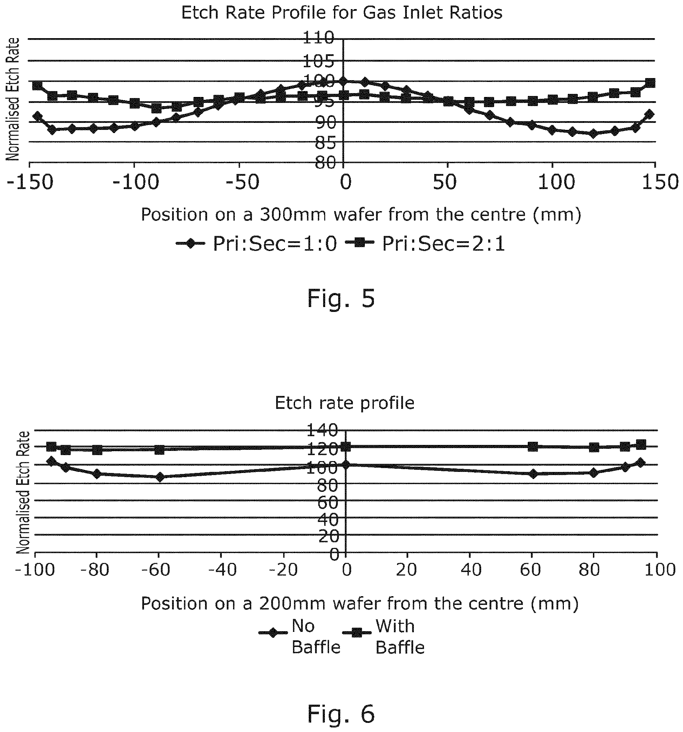

The benefit of having an independent annular gas supply to the secondary RF source can be seen in Figure 5. Here the normalized etch rate for a 300 mm wafer can be seen gas flow solely to the primary source and when gas is supplied with a ratio of 2:1 between the primary and secondary sources. Increasing the gas flow to the annular gas supply to the main chamber improves the uniformity of the plasma and in turn improves etch uniformity.

In Figure 6 we can see the benefit of utilizing a conductance limiting path (baffle/WEP channel) at the edge of the wafer. Uniformity can be improved by reducing the depletion of reactive species at the wafer periphery and reducing the number of ions. This improves the uniformity across the wafer and therefore also allows a higher etch rate for a given uniformity by adjusting other process parameters which would normally worsen the uniformity.

The invention could be applied to semiconductor wafers, wafers on carriers or wafer in frames. The principal adjustment is the positioning of the WEP and the baffle to ensure the conductance limiting path is controlled to improve edge uniformity. In the case of wafers in frames the WEP would cover the frame and much of the exposed tape but not the wafer edge.

Numerous variations to the specific embodiments described above are within the scope of the invention. For example, instead of using Faraday shields, an alternative means may be used to reduce stray electric coupling, such as a segmented coil. Such a coil structure could be mounted inside a chamber, as described in US 6495963. Alternative magnetic plasma confinement means may be used in place of DC coils, and in other embodiments no magnetic plasma confinement means are used at all. The frequencies of the RF sources do not have to be the same, and any suitable combination of frequencies might be used. A non-limiting range of possible frequencies is 1-13.56 MHz. The invention is defined by the claims.

## Claims

1. An apparatus (10) for processing a semiconductor workpiece (24) including:
a first chamber (14) having a first plasma production source (16, 18, 20) and a first gas supply (12) for introducing a supply of gas into the first chamber;
a second chamber (22) having a second plasma production source (30, 32) and a second gas supply (34) for introducing a supply of gas into the second chamber, the second gas supply being independently controllable of the first gas supply;
a workpiece support (26) positioned in the second chamber; a plurality of gas flow pathway defining elements (28, 36) arranged to define a gas flow pathway in the vicinity of the workpiece when positioned on the workpiece support, wherein the gas flow pathway defining elements include at least one wafer edge region protection element (28) for protecting the edge of the wafer and/or a region outwardly circumjacent to the edge of the wafer, and at least one auxiliary element (36) spaced apart from the at least one wafer edge region protection element such that the gas flow pathway is defined;
**characterized in that** the at least one auxiliary element is spaced apart from the at least one wafer edge region protection element such that a gap of between 5 and 50 mm is defined.

2. An apparatus according to claim 1 in which the at least one wafer edge region protection device element is an annular wafer edge protection device.

3. An apparatus according to claim 1 or claim 2 in which the at least one auxiliary element includes one or more baffles.

4. An apparatus according to claim 3 in which the at least one auxiliary element is an annular baffle.

5. An apparatus according to any previous claim in which the at least one auxiliary element (46) is positioned over an inner portion of the at least one wafer edge region protection element.

6. An apparatus according to any one of claims 1 to 4 in which the at least one auxiliary element (36) is positioned over an outer part of the at least one wafer edge region protection element.

7. An apparatus according to any previous claim in which the at least one auxiliary element (46) extends radially inward of the wall of the second chamber.

8. An apparatus according to any one of claims 1 to 6 in which the at least one auxiliary element (36) extends downwardly from the wall of the second chamber.

9. An apparatus according to any previous claim in which the at least one auxiliary element is spaced apart from the at least one wafer edge region protection element such that a gap of between 15 and 25 mm is defined.

10. An apparatus according to any previous claim in which the gas flow pathway extends radially outwards from the workpiece when positioned on the workpiece support.

11. An apparatus according to any previous claim comprising a carrier (42, 44) arranged such that the workpiece, when positioned on the workpiece support, is supported by the carrier (42, 44), and the at least one wafer edge region protection element is arranged to protect the carrier.

12. An apparatus according to claim 11 in which the carrier is of the tape and frame kind, and the at least one wafer edge protection element is arranged to protect the tape (42) and/or the frame (44).

13. An apparatus according to any previous claim in which the first plasma production source includes an element (18) for coupling energy into the first chamber such that a plasma induced in the first chamber is maintained, and the second plasma production source includes an element (32) for coupling energy into the second chamber such that a plasma induced in the second chamber is maintained, wherein the element of the first plasma production source is spaced apart from the element of the second plasma production source such that the plasma induced in the first chamber is decoupled from the plasma induced in the second chamber.

14. An apparatus according to claim 13 in which the first chamber is arranged to meet the second chamber at an interface having an associated level, and at least one of the elements of the first plasma production source and the elements of the second plasma production source is spaced apart from said level.

## Patentansprüche

1. Vorrichtung (10) zur Bearbeitung eines Halbleiterwerkstücks (24), umfassend:
eine erste Kammer (14) mit einer ersten Plasmaerzeugungsquelle (16, 18, 20) und einem ersten Gasanschluss (12) zum Einbringen einer Gasbelieferung in die erste Kammer;
eine zweite Kammer (22) mit einer zweiten Plasmaerzeugungsquelle (30, 32) und einem zweiten Gasanschluss (34) zum Einbringen einer Gasbelieferung in die zweite Kammer, wobei die zweite Gasbelieferung unabhängig von der ersten Gasbelieferung steuerbar ist;
eine Werkstückhalterung (26), die in der zweiten Kammer positioniert ist;
mehrere den Gasströmungspfad definierende Elemente (28, 36), die so angeordnet sind, dass sie einen Gasströmungspfad in der Nähe des Werkstücks definieren, wenn es auf der Werkstückhalterung positioniert ist, wobei die den Gasströmungspfad definierenden Elemente mindestens ein Waferkantenbereich-Schutzelement (28) zum Schutz der Kante des Wafers und/oder eines außen um die Kante des Wafers liegenden Bereichs und mindestens ein Hilfselement (36), das von dem mindestens einen Waferkantenbereich-Schutzelement derart beabstandet ist, dass der Gasströmungspfad definiert wird, umfassen;
**dadurch gekennzeichnet, dass** das mindestens eine Hilfselement von dem mindestens einen Waferkantenbereich-Schutzelement derart beabstandet ist, dass ein Spalt zwischen 5 und 50 mm definiert wird.

2. Vorrichtung nach Anspruch 1, wobei das mindestens eine Waferkantenbereich-Schutzelement eine ringförmige Waferkantenschutzvorrichtung ist.

3. Vorrichtung nach Anspruch 1 oder Anspruch 2, wobei das mindestens eine Hilfselement ein oder mehrere Baffles umfasst.

4. Vorrichtung nach Anspruch 3, wobei das mindestens eine Hilfselement ein ringförmiges Baffle ist.

5. Vorrichtung nach einem der vorhergehenden Ansprüche, wobei das mindestens eine Hilfselement (46) über einem inneren Abschnitt des mindestens einen Waferkantenbereich-Schutzelements positioniert ist.

6. Vorrichtung nach einem der Ansprüche 1 bis 4, wobei das mindestens eine Hilfselement (36) über einem äußeren Teil des mindestens einen Waferkantenbereich-Schutzelements positioniert ist.

7. Vorrichtung nach einem der vorhergehenden Ansprüche, wobei sich das mindestens eine Hilfselement (46) von der Wand der zweiten Kammer radial nach innen erstreckt.

8. Vorrichtung nach einem der Ansprüche 1 bis 6, wobei sich das mindestens eine Hilfselement (36) von der Wand der zweiten Kammer nach unten erstreckt.

9. Vorrichtung nach einem der vorhergehenden Ansprüche, wobei das mindestens eine Hilfselement von dem mindestens einen Waferkantenbereich-Schutzelement derart beabstandet ist, dass ein Spalt zwischen 15 und 25 mm definiert wird.

10. Vorrichtung nach einem der vorhergehenden Ansprüche, wobei sich der Gasströmungspfad vom Werkstück radial nach außen erstreckt, wenn es auf der Werkstückhalterung positioniert ist.

11. Vorrichtung nach einem der vorhergehenden Ansprüche, umfassend einen Träger (42, 44), der derart angeordnet ist, dass das Werkstück, wenn es auf der Werkstückhalterung positioniert ist, von dem Träger (42, 44) getragen wird und das mindestens eine Waferkantenbereich-Schutzelement so angeordnet ist, dass es den Träger schützt.

12. Vorrichtung nach Anspruch 11, wobei der Träger vom Band- und Rahmentyp ist und wobei das mindestens eine Waferkanten-Schutzelement angeordnet ist, um das Band (42) und/oder den Rahmen (44) zu schützen.

13. Vorrichtung nach einem der vorhergehenden Ansprüche, wobei die erste Plasmaerzeugungsquelle ein Element (18) zum Einkoppeln von Energie in die erste Kammer aufweist, derart, dass ein in der ersten Kammer induziertes Plasma aufrechterhalten wird, und wobei die zweite Plasmaerzeugungsquelle ein Element (32) zum Einkoppeln von Energie in die zweite Kammer aufweist, derart, dass ein in der zweiten Kammer induziertes Plasma aufrechterhalten wird, wobei das Element der ersten Plasmaerzeugungsquelle von dem Element der zweiten Plasmaerzeugungsquelle beabstandet ist, sodass das in der ersten Kammer induzierte Plasma von dem in der zweiten Kammer induzierten Plasma entkoppelt ist.

14. Vorrichtung nach Anspruch 13, wobei die erste Kammer so angeordnet ist, dass sie mit der zweiten Kammer an einer Grenzfläche mit einem zugehörigen Niveau zusammentrifft, und mindestens eines der Elemente der ersten Plasmaerzeugungsquelle und der Elemente der zweiten Plasmaerzeugungsquelle von dem Niveau beabstandet ist.

## Revendications

1. Appareil (10) de traitement d'une pièce à semi-conducteur (24), comprenant :
une première chambre (14) ayant une première source de production de plasma (16, 18, 20) et une première alimentation en gaz (12) pour introduire une alimentation en gaz dans la première chambre ;
une seconde chambre (22) ayant une seconde source de production de plasma (30, 32) et une seconde alimentation en gaz (34) pour introduire une alimentation en gaz dans la seconde chambre, la seconde alimentation en gaz pouvant être commandée indépendamment de la première alimentation en gaz ;
un porte-pièce (26) positionné dans la seconde chambre ;
une pluralité d'éléments définissant une voie d'écoulement de gaz (28, 36) disposés de manière à définir une voie d'écoulement de gaz à proximité de la pièce lorsqu'elle est positionnée sur le porte-pièce, les éléments définissant la voie d'écoulement de gaz comprenant au moins un élément de protection de région de bord de tranche (28) pour protéger le bord de la tranche et/ou une région extérieurement circonférentielle au bord de la tranche, et au moins un élément auxiliaire (36) espacé de l'au moins un élément de protection de région de bord de tranche de telle sorte que la voie d'écoulement de gaz est définie ;
**caractérisé en ce que** l'au moins un élément auxiliaire est espacé de l'au moins un élément de protection de région de bord de tranche de telle sorte qu'un espace compris entre 5 et 50 mm est défini.

2. Appareil selon la revendication 1, dans lequel l'au moins un élément de protection de région de bord de tranche est un dispositif de protection de bord de tranche annulaire.

3. Appareil selon la revendication 1 ou 2, dans lequel l'au moins un élément auxiliaire comprend une ou plusieurs chicanes.

4. Appareil selon la revendication 3, dans lequel l'au moins un élément auxiliaire est une chicane annulaire.

5. Appareil selon l'une quelconque des revendications précédentes, dans lequel l'au moins un élément auxiliaire (46) est positionné sur une partie intérieure de l'au moins un élément de protection de région de bord de tranche.

6. Appareil selon l'une quelconque des revendications 1 à 4, dans lequel l'au moins un élément auxiliaire (36) est positionné sur une partie extérieure de l'au moins un élément de protection de région de bord de tranche.

7. Appareil selon l'une quelconque des revendications précédentes, dans lequel l'au moins un élément auxiliaire (46) s'étend radialement vers l'intérieur de la paroi de la seconde chambre.

8. Appareil selon l'une quelconque des revendications 1 à 6, dans lequel l'au moins un élément auxiliaire (36) s'étend vers le bas depuis la paroi de la seconde chambre.

9. Appareil selon l'une quelconque des revendications précédentes, dans lequel l'au moins un élément auxiliaire est espacé de l'au moins un élément de protection de région de bord de tranche de telle sorte qu'un espace compris entre 15 et 25 mm est défini.

10. Appareil selon l'une quelconque des revendications précédentes, dans lequel la voie d'écoulement de gaz s'étend radialement vers l'extérieur à partir de la pièce lorsqu'elle est positionnée sur le porte-pièce.

11. Appareil selon l'une quelconque des revendications précédentes, comprenant un support (42, 44) disposé de telle sorte que la pièce, lorsqu'elle est positionnée sur le porte-pièce, est supportée par le support (42, 44), et l'au moins un élément de protection de région de bord de tranche est disposé de manière à protéger le support.

12. Appareil selon la revendication 11, dans lequel le support est du type bande et cadre, et l'au moins un élément de protection de bord de tranche est disposé de manière à protéger la bande (42) et/ou le cadre (44).

13. Appareil selon l'une quelconque des revendications précédentes, dans lequel la première source de production de plasma comprend un élément (18) pour coupler l'énergie dans la première chambre de telle sorte qu'un plasma induit dans la première chambre est maintenu, et la seconde source de production de plasma comprend un élément (32) pour coupler l'énergie dans la seconde chambre de telle sorte qu'un plasma induit dans la seconde chambre est maintenu, dans lequel l'élément de la première source de production de plasma est espacé de l'élément de la seconde source de production de plasma de telle sorte que le plasma induit dans la première chambre est découplé du plasma induit dans la seconde chambre.

14. Appareil selon la revendication 13, dans lequel la première chambre est disposée de manière à rencontrer la seconde chambre à une interface ayant un niveau associé, et l'élément de la première source de production de plasma et/ou l'élément de la seconde source de production de plasma est espacé dudit niveau.
